# EUROPEAN PATENT APPLICATION

(11) **EP 2 975 157 A1**
(43) Date of publication of application: **20.01.2016**
(21) Application number: 15172545.4
(22) Date of filing: 17.06.2015
(51) Int. Cl.: C23C 16/455, C23C 16/44, C30B 25/14

(54) **GAS FLOW FLANGE FOR A ROTATING DISK REACTOR FOR CHEMICAL VAPOR DEPOSITION**

(30) Priority: 17.06.2014 US 201414306398
(71) Applicant: Veeco Instruments Inc., Plainview, NY 11803 (US)
(72) Inventor: Luse, Todd A., Kings Park, New York 11754 (US); Fremgen, Roger P., Northport, New York 11768 (US)
(74) Representative: Jackson, Robert Patrick

(57) **Abstract**

A gas flow flange for a rotating disk reactor for chemical vapor deposition, the gas flow flange comprising: a) a first section comprising a plurality of first gas input channels positioned inside and parallel to a top surface of the first section, and a plurality of second gas input channels positioned perpendicular to the top surface of the first section and extending from the top surface to a bottom surface of the first section; and b) a second section comprising: 1) a plurality of first gas input channels positioned perpendicular to a top surface of the second section and extending through the top surface to a bottom surface of the second section, each of the plurality of first gas input channels of the second section being aligned with an output of a corresponding one of the plurality of first gas input channels in the first section; 2) a plurality of second gas input channels positioned perpendicular to and extending from the top surface to the bottom surface of the second section, each of the plurality of second gas input channels being aligned with a corresponding one of the plurality of second gas input channels in the first section; and 3) fluid cooling conduits that are formed in the second section and extending parallel to the top surface of the second section.

## Description

The section headings used herein are for organizational purposes only and should not be construed as limiting the subject matter described in the present application in any way.

### Introduction

Vapor phase epitaxy (VPE) is a type of chemical vapor deposition (CVD), which involves directing one or more gases containing chemical species onto a surface of a substrate so that the reactive species react and form a film on the surface of the substrate. For example, VPE systems can be used to grow compound semiconductor materials on substrates.

Materials are typically grown by injecting at least one precursor gas and, in many processes, at least a first and a second precursor gas into a process chamber containing the crystalline substrate. Compound semiconductors, such as III-V semiconductors, can be formed by growing various layers of semiconductor materials on a substrate using a hydride precursor gas and an organometalic precursor gas. Metalorganic vapor phase epitaxy (MOVPE) is a vapor deposition method that is commonly used to grow compound semiconductors using a surface reaction of metalorganics and hydrides containing the required chemical elements. For example, indium phosphide could be grown in a reactor on a substrate by introducing trimethylindium and phosphine.

Alternative names for MOVPE used in the art include organometallic vapor phase epitaxy (OMVPE), metalorganic chemical vapor deposition (MOCVD), and organometallic chemical vapor deposition (OMCVD). In these processes, the gases are reacted with one another at the growth surface of a substrate, such as a sapphire, Si, GaAs, InP, InAs, or GaP substrate, to form a III-V compound of the general formula In_{X}Ga_{Y}Al_{Z}N_{A}As_{B}P_{C}Sb_{D}, where X+Y+Z equals approximately one, and A+B+C+D equals approximately one, and each of X, Y, Z, A, B, C, and D can be between zero and one. In various processes, the substrate can be a metal, semiconductor, or an insulating substrate. In some instances, bismuth may be used in place of some or all of the other Group III metals.

Compound semiconductors, such as III-V semiconductors, can also be formed by growing various layers of semiconductor materials on a substrate using a hydride or a halide precursor gas process. In one halide vapor phase epitaxy (HVPE) process, Group III nitrides (e.g., GaN, AlN) are formed by reacting hot gaseous metal chlorides (e.g., GaCl or AlCl) with ammonia gas (NH₃). The metal chlorides are generated by passing hot HCl gas over the hot Group III metals. One feature of HVPE is that it can have a very high growth rate, up to 100 µm per hour for some state-of-the-art processes. Another feature of HVPE is that it can be used to deposit relatively high quality films because films are grown in a carbon free environment and because the hot HCl gas provides a self-cleaning effect.

In these processes, the substrate is maintained at an elevated temperature within a reaction chamber. The precursor gases are typically mixed with inert carrier gases and are then directed into the reaction chamber. Typically, the gases are at a relatively low temperature when they are introduced into the reaction chamber. As the gases reach the hot substrate, their temperatures, and hence their available energies for reaction, increase. Formation of the epitaxial layer occurs by final pyrolysis of the constituent chemicals at the substrate surface. Crystals are formed by a chemical reaction on the surface of the substrate and not by physical deposition processes. Consequently, VPE is a desirable growth technique for thermodynamically metastable alloys. Currently, VPE is commonly used for manufacturing laser diodes, solar cells, and light emitting diodes (LEDs).

### Summary of the Invention

A first aspect of the present invention provides a gas flow flange for a rotating disk reactor for chemical vapor deposition which includes a first section comprising a plurality of first gas input channels positioned inside and parallel to a top surface of the first section and a plurality of second gas input channels positioned perpendicular to the top surface of the first section and extending from the top surface to a bottom surface of the first section. A second section of the gas flow flange includes a plurality of first gas input channels positioned perpendicular to a top surface of the second section and extending through the top surface to a bottom surface of the second section, where each of the plurality of first gas input channels of the second section are aligned with an output of a corresponding one of the plurality of first gas input channels in the first section. In addition, the second section of the gas flow flange includes a plurality of second gas input channels positioned perpendicular to, and extending from, the top surface to the bottom surface of the second section, where each of the plurality of second gas input channels is aligned with a corresponding one of the plurality of second gas input channels in the first section. In addition, the gas flow flange may include fluid cooling conduits that are formed in the second section and extend parallel to the top surface of the second section.

The first and second sections preferably separate first and second gases so that they do not react until they are at the substrate surface. In some systems, the plurality of first gas input channels is coupled to an output of an alkyl gas source and/or the plurality of second gas input channels is coupled to an output of a hydride gas source. In some embodiments, a view port is coupled to an input port of the first section. In some embodiments, at least some of the second gas input channels of the second section are formed in a shape where their cross-sectional area increases from the top surface to the bottom surface.

One feature of the gas flow flange of the present teaching is the two piece design, that may be fabricated with three-dimensional metal printing, which has numerous benefits. The first and second sections can be attached in various ways. For example, the first section can include a plurality of recessed slots dimensioned to receive a threaded fastener, and the second section can include a plurality of threaded sections aligned with the recessed slots for receiving the threaded fastener. Also, one of the first and second sections can include a plurality of alignment pins and the other of the first and second sections can define a plurality of apertures dimensioned to receive the plurality of alignment pins.

In some gas flow flanges according to the present teaching, an input port receives a fluid that passes from a central location of the second section in an outward direction to an output port. The fluid cooling conduits are designed to pass liquids, such as water, and gasses, such as air. In various embodiments, the cooling conduits can be circular or shaped to maximize the volume of fluids passing through. For example, the cooling conduits can be teardrop shaped, oval shaped, generally triangular, or can be shaped to maintain a predetermined thickness of material from the outer surface.

A second aspect of the present invention provides a method of separating a first and second gas for injection into a reaction chamber, the method comprising: providing the first gas to a plurality of first gas input channels positioned inside and parallel to a top surface of a first section of a flow flange, so that the first gas flows from the plurality of first gas input channels of the first section of the flow flange to a corresponding plurality of first gas input channels of a second section of the flow flange, the plurality of first gas input channels of the second section of the flow flange being positioned perpendicular to the top surface of the second section of the flow flange and extending from the top surface to a bottom surface of the second section of the flow flange, and then into a reaction chamber; and providing the second gas to a plurality of second gas input channels that are positioned perpendicular to the top surface of the first section of the flow flange and extending from the top surface to the bottom surface of the first section of the flow flange, and then extending from the top surface of the second section to the bottom surface of the second section, and then into the reaction chamber.

A third aspect of the present invention provides a gas flow flange for a rotating disk reactor for chemical vapor deposition, the gas flow flange comprising: a means for providing a first gas to a reaction chamber by providing a plurality of first gas input channels positioned inside and parallel to a top surface of a first section of a flow flange so that the first gas flows parallel to the top surface of the first section of the flow flange to a corresponding plurality of first gas input channels of a second section of the flow flange, which are positioned perpendicular to the top surface of the second section of the flow flange and extending from the top surface to a bottom surface of the second section of the flow flange, and then into a reaction chamber; and a means for providing a second gas to the reaction chamber by first providing a plurality of second gas input channels that are positioned perpendicular to the top surface of the first section of the flow flange and extending from the top surface to the bottom surface of the first section flow flange, and then extending from the top surface of the second section to the bottom surface of the second section, and then into the reaction chamber.

### Brief Description of the Drawings

The present teaching, in accordance with preferred and exemplary embodiments, together with further advantages thereof, is more particularly described in the following detailed description taken in conjunction with the accompanying drawings. The skilled person in the art will understand that the drawings, described below, are for illustration purposes only. The drawings are not necessarily to scale, emphasis instead generally being placed upon illustrating principles of the teaching. In the drawings, like reference characters generally refer to like features and structural elements throughout the various figures. The drawings are not intended to limit the scope of the Applicants' teaching in any way.
FIG. 1A illustrates a cross-section of one embodiment of a rotating disk chemical vapor deposition reactor according to the present teaching.
FIG. 1B illustrates a cross-section of another embodiment of a rotating disk chemical vapor reactor according to the present teaching.
FIG. 2 illustrates a side-view of a gas flow flange for a rotating disk chemical vapor deposition reactor according to the present teaching.
FIG. 3 illustrates a side-perspective view of a gas flow flange for a rotating disk reactor for chemical vapor deposition according to the present teaching.
FIG. 4 illustrates a top-view of a gas flow flange for a rotating disk reactor for chemical vapor deposition according to the present teaching.
FIG. 5A illustrates a temperature distribution diagram showing circular cooling conduits positioned around the plurality of first gas input channels, as shown in the gas flow flange of FIG. 3.
FIG. 5B illustrates a temperature distribution diagram showing teardrop shaped cooling conduits positioned around the plurality of first gas input channels.
FIG. 5C illustrates a temperature distribution diagram showing deep teardrop shaped cooling conduits positioned around the plurality of first gas input channels.

### Description of Various Embodiments

Reference in the specification to "one embodiment" or "an embodiment" means that a particular feature, structure, or characteristic, described in connection with the embodiment is included in at least one embodiment of the teaching. The appearances of the phrase "in one embodiment" in various places in the specification are not necessarily all referring to the same embodiment.

It should be understood that the individual steps used in the methods of the present teachings may be performed in any order and/or simultaneously, as long as the teaching remains operable. Furthermore, it should be understood that the apparatus and methods of the present teachings can include any number, or all, of the described embodiments, as long as the teaching remains operable.

The present teaching will now be described in more detail with reference to exemplary embodiments thereof as shown in the accompanying drawings. While the present teachings are described in conjunction with various embodiments and examples, it is not intended that the present teachings be limited to such embodiments. On the contrary, the present teachings encompass various alternatives, modifications, and equivalents, as will be appreciated by those of skill in the art. Those of ordinary skill in the art, having access to the teaching herein, will recognize additional implementations, modifications, and embodiments, as well as other fields of use, which are within the scope of the present disclosure as described herein.

The present teaching relates to methods and apparatuses for chemical vapor deposition, including MOCVD. More particularly, the present teaching relates to methods and apparatuses for chemical vapor deposition using vertical reactors in which the substrates are located on a rotating disk. Recently, there has been tremendous growth in the LED and OLED markets. Also, there have been significant advances in semiconductor power devices (e.g., HEMT), which have increased their utility. Consequently, there has been an increased demand for efficient and high throughput CVD and MOCVD manufacturing systems and methods to fabricate these devices. There is a particular need for manufacturing systems and methods that improve deposition uniformity without negatively impacting the maintenance and operating parameters, such as rotation rate of the substrate carrier.

Features of the present teaching are described in connection with a flow flange that flows two different process gases, such as alky and hydride gasses, into a reaction chamber. However, one skilled in the art will appreciate that the flow flange of the present teaching can be used to flow more than two different gases into the reaction chamber while preventing the various gasses from mixing prior to injection into the reaction chamber.

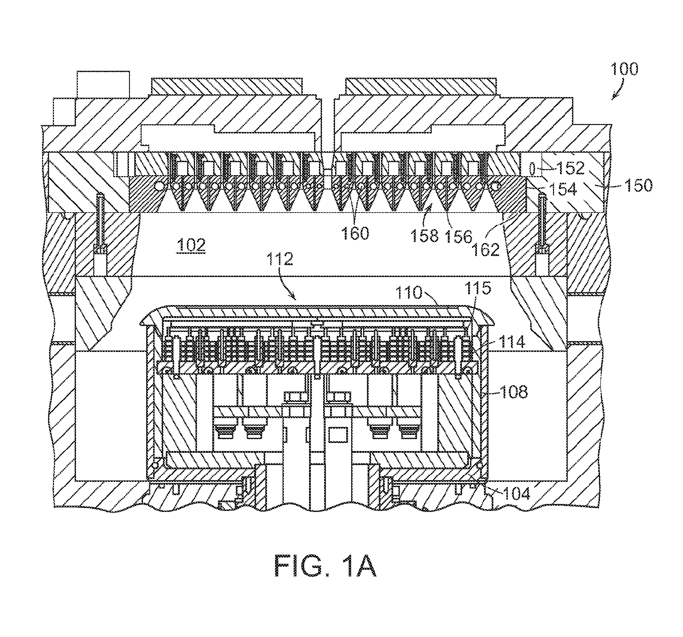

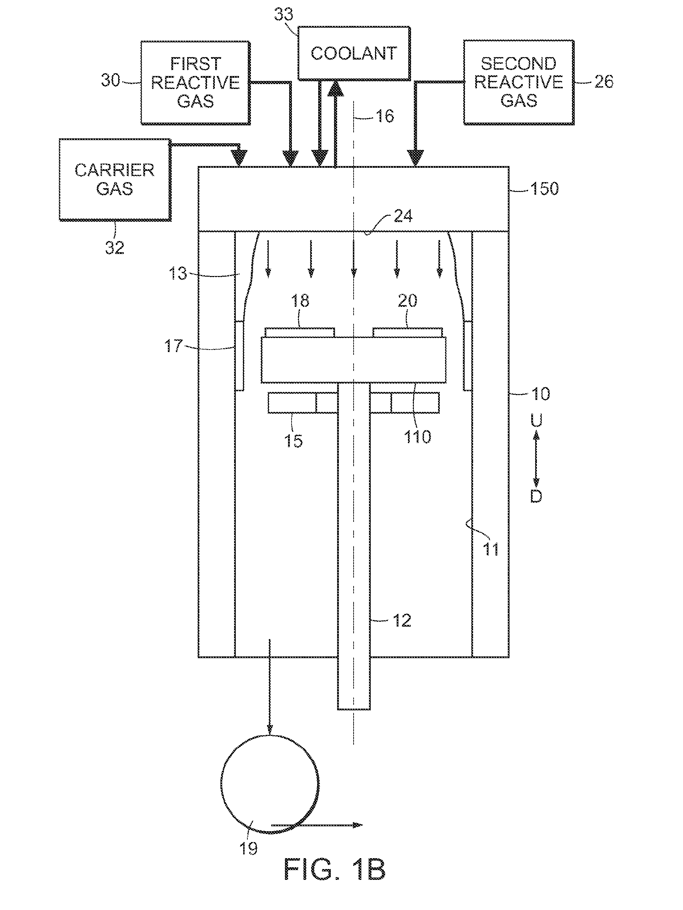

FIG. 1A illustrates a cut-away view of a rotating disk chemical vapor deposition (CVD) reactor 100 that includes the two-piece flow flange according to the present teaching. One skilled in the art will appreciate that the CVD reactor 100 described in connection with FIG. 1 is one particular CVD reactor that can be used with the two-piece flow flange according to the present teaching. Some aspects of the CVD reactor 100 are described in more detail in PCT Patent Application, Serial Number PCT/US2013/40246, entitled, "Rotating Disk Reactor with Ferrofluid Seal for Chemical Vapor Deposition," which is assigned to the present Applicant. The entire contents of the PCT Patent Application, Serial Number PCT/US2013/40246, are herein incorporated by reference. The particular design of the CVD reactor does not limit the teachings described herein. There are numerous variations of CVD reactors that can be used with the two-piece flow flange according to the present teaching.

The CVD reactor 100 includes a vacuum chamber 102, which is often formed of stainless steel. The vacuum chamber 102 provides a vacuum environment for CVD processing of a single substrate or of a batch of substrates. One example of a process that can be performed with a CVD reactor, according to the present teaching, is depositing thin films by CVD, such as GaN based, thin films grown on sapphire substrates for LED manufacturing.

A turntable 104 is positioned in a cool region 106 of the vacuum chamber 102. The cool region 106 is maintained at a relatively low temperature during normal processing conditions so that it can enclose relatively low temperature components. The bottom of the turntable 104 includes a bearing or guide wheel system that allows for rotation. A rotating dielectric support 108 is positioned on top of the turntable 104. The dielectric support 108 can be mechanically or magnetically coupled to the turntable 104 by various means. In one embodiment of the present teaching, the dielectric support 108 is a hollow dielectric cylinder or tube that attaches to the turntable 104 as shown in FIG. 1. In various other embodiments, the rotating dielectric support 108 is formed of various other shapes. One feature of the present teaching is that the length of the rotating dielectric support 108 can be significantly shorter than similar structures formed of metallic materials or high thermal conductivity dielectric materials, which are used in other known CVD reactors.

A substrate carrier 110 is positioned on top of the rotating dielectric support 108. The substrate carrier 110 has at least one recessed portion that is dimensioned to receive at least one substrate for processing. In one embodiment, the substrate carrier 110 is a single substrate carrier.

The substrate carrier 110 can be mechanically attached to the rotating dielectric support 108 or can be freely positioned on the top surface of the rotating dielectric support 108 and held in place by only friction. The CVD system of the present teaching uses various means of thermal isolation or thermal breaking in the interface between the substrate carrier 110 and the rotating dielectric support 108. One such means of thermal breaking is to form rounded edges of the substrate carrier 110 to reduce thermal losses at the edge of the substrate carrier 110. Another means for thermal breaking is to reduce heat transfer between the bottom of the substrate carrier 110 and the dielectric support 108.

In some embodiments, a shutter or gate in the vacuum chamber 102 opens to allow the substrate carrier 110 to transfer into and out of a reaction area 112 of the vacuum chamber 102. In many embodiments, the substrate carrier 110 has a lip or other edge feature, which allows a robotic arm to transport it into and out of the vacuum chamber 102.

In other embodiments of the present teaching, the substrate carrier 110 is a multi-substrate carrier mounted within a CVD reactor, an example of which is shown in FIG. 1B.

The reactor in FIG. 1B includes a reaction chamber 10 having walls with interior surfaces 11 substantially in the form of surfaces of revolution about a central axis 16. The reactor walls may include a tapering section 13 adjacent to an upstream end of the reactor, and also may include a movable hoop-like section 17. A spindle 12 is mounted in the chamber for rotation around axis 16. A disc-like substrate carrier 110 is mounted on the spindle. The substrate carrier 110 is arranged to hold one or more substrates, such as wafers 18, so that surfaces 20 of the wafers face in an upstream direction U along the axis. Movable hoop-like section 17 forms a shutter that extends around the wafer carrier 14 when the system is in an operative condition as shown. The shutter can be moved axially to open a port for loading and unloading the system. Typically, the substrate carrier 110 is detachably mounted on the spindle, so that the system can be unloaded by removing a substrate carrier, and reloaded by inserting a new substrate carrier. Gas flow flange 150 is described in more detail below.

A heater 15, such as an electrical resistance heater, is provided within the reactor for heating the substrate carrier and wafers. Also, an exhaust system 19 is connected to the downstream end of the reaction chamber.

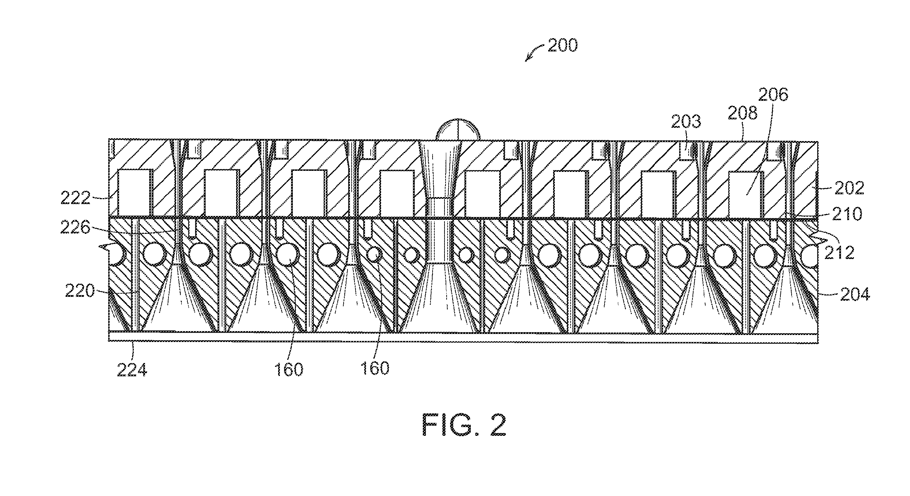

A gas flow flange 150 according to the present teaching is shown above the substrate carrier 110. The gas flow flange 150 is described in detail in connection with FIGS. 2-4 below. The gas flow flange 150 includes a first section 152 and a second section 154 that are fastened together after fabrication, before assembling the CVD reactor 100 system. The gas flow flange 150 prevents mixing of a first and second gas in the flange before injection proximate to the substrate carrier 110. In operation, a first gas, such as an alkyl gas, is injected from a first plurality of gas input channels 156 in the second section 154, and a second gas, such as a hydride gas, is injected from a second plurality of gas input channels 158 in the second section 154. The gas flow flange 150 includes cooling channels 160 that keep the bottom surface 162 of the gas flow flange 150 cool during operation.

FIG. 2 illustrates a side-view of a gas flow flange 200 for a rotating disk reactor for chemical vapor deposition according to the present teaching. The gas flow flange 200 includes a first section 202 and a second section 204 that are fastened together. In various embodiments, the first and second sections 202, 204 are fastened together using any one of numerous types of mechanical fasteners, such as fine thread screws, rivets, pins, and bolts that are positioned in a plurality of recessed slots 203 in the top surface 208 of the first section 202. Snap fasteners and clamps can also be used. In some embodiments, one of the first and second sections 202, 204 comprises a plurality of alignment pins, and the other of the first and second sections 202, 204 defines a corresponding plurality of apertures dimensioned to receive the plurality of alignment pins. At least one of the first and second sections 202, 204 can be formed by three-dimensional metal printing.

The first and second sections 202, 204 separate first and second gases so that they do not react until they leave the gas flow flange 200. The first section 202 includes a plurality of first gas input channels 206 positioned inside and parallel to a top surface 208 of the first section 202. The first section 202 also includes a plurality of second gas input channels 210 positioned perpendicular to the top surface 208 of the first section 202 and extending from the top surface 208 to a bottom surface 212 of the first section 202. In one embodiment, the plurality of first gas input channels 206 is coupled to an output of an alkyl gas source, and the plurality of second gas input channels 210 is coupled to an output of a hydride gas source.

The second section 204 also includes a plurality of first gas input channels 220 positioned perpendicular to a top surface 222 of the second section 204 and extending through the top surface 222 to a bottom surface 224 of the second section 204. Each of the plurality of first gas input channels 220 are aligned with an output of a corresponding one of the plurality of first gas input channels 206 in the first section 202.

The second section 204 also includes a plurality of second gas input channels 226 that are positioned perpendicular to, and extending from, the top surface 222 to the bottom surface 224 of the second section 204. Each of the plurality of second gas input channels 226 in the second section 204 are aligned with a corresponding one of the plurality of second gas input channels 210 in the first section 202. In many embodiments, the second gas input channels 226 in the second section 204 positioned perpendicular to, and extending from, the top surface 222 to the bottom surface 224 of the second section 204 have an increasing diameter towards the bottom surface 224. In some embodiments, at least some of the second gas input channels 226 in the second section 204 positioned perpendicular to, and extending from, the top surface 222 to the bottom surface 224 of the second section 204 are formed in the shape of a cone 230. The second section 204 also includes a plurality of threaded sections 230 aligned with the plurality of recessed slots 203 in the first section 202 that are dimensioned to receive threaded fasteners.

A plurality of fluid cooling conduits 160 is positioned perpendicular to the top and bottom surfaces 222, 224 of the second section 204. The plurality of fluid cooling conduits 160 can have various shapes to improve or to maximize heat transfer from the gas flow flange 200 into the cooling fluid. In one embodiment, the plurality of fluid cooling conduits 160 comprises an input port that receives a fluid that passes from a central location of the second section 204 in an outward direction to an output port of the flow flange 200. Numerous fluid cooling conduit shapes and patterns can be inexpensively achieved with modern three-dimensional metal printing techniques.

In various embodiments, these fluid cooling conduits 160 have varying cross-sectional areas depending on their position in the second section 204 and how much space is physically available between the first and second gas input channels 220, 226 for the cooling conduit. In various embodiments, the fluid cooling conduits can pass any type of cooling fluid, including liquids, such as water, and gasses, such as air. The cooling fluid controls the temperature in a range that is chosen to maintain acceptable thermal expansion and to promote gas mixing.

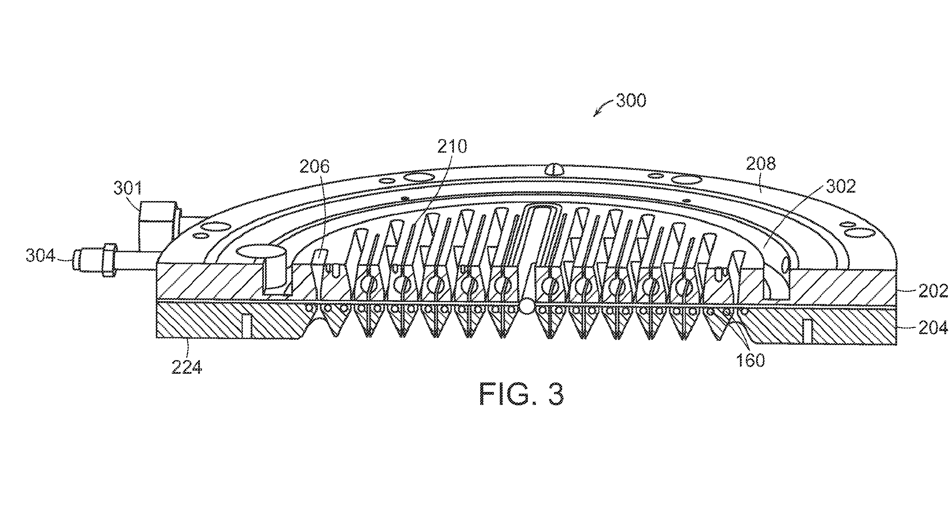

FIG. 3 illustrates a side-perspective view of a gas flow flange 300 for a rotating disk reactor for chemical vapor deposition according to the present teaching. The side-perspective view of the gas flow flange 300 more clearly shows some features of the gas flow flange 200 in FIG. 2. For example, the side-perspective view of the gas flow flange 300 shows the view port 301. Also, the side-perspective view of the gas flow flange 300 more clearly shows how the first and second sections 202, 204 separate first and second gases so that they do not react until they leave the bottom surface 224 of the second section 204 of the gas flow flange 200.

The plurality of first gas input channels 206 positioned inside and parallel to a top surface 208 of the first section 202 is coupled to an annular channel 302. Gas passes from a gas inlet 304 to an annular channel 302, and then from the annular channel 302 into the plurality of first gas input channels 206, where it flows downward towards the second section 204 proximate to the substrate carrier 110. For some chemical vapor deposition processes, the gas inlet 304 is coupled to an output of an alkyl gas source.

In addition, the plurality of second gas input channels 210 positioned perpendicular to the top surface 208 of the first section 202 and extending from the top surface 208 to the bottom surface 224 of the second section 204 are shown as slots extending from the top surface 208 of the first section 202 to the bottom surface 224 of the second section 204, where the cross sectional area of the plurality of second gas input channels 210 increases to a cone-like shape and then passes to the substrate carrier 110. For some chemical vapor deposition processes, a hydride gas source is coupled to the plurality of second gas input channels 210 at the top surface 208 of the first section 202. Gas passing through the cone like shape outlet flows from the bottom surface 224 of the second section 204 towards the substrate carrier 110.

The side-perspective view of the gas flow flange 300 shown in FIG. 3 more clearly illustrates the plurality of cooling conduits 160 positioned perpendicular to the top and bottom surfaces 222, 224 of the second section 204. The cross-sectional areas of the cooling conduits 160 can be substantially the same as shown in FIG. 3, or can have various cross-sectional areas that are chosen to maximize the volume of the fluid, thus maximizing the heat transfer from the gas flow flange 300. In the embodiment shown in FIG. 3, the cooling fluid enters the plurality of fluid cooling conduits 160 at a central location, and then flows through the plurality of cooling conduits in an outward direction.

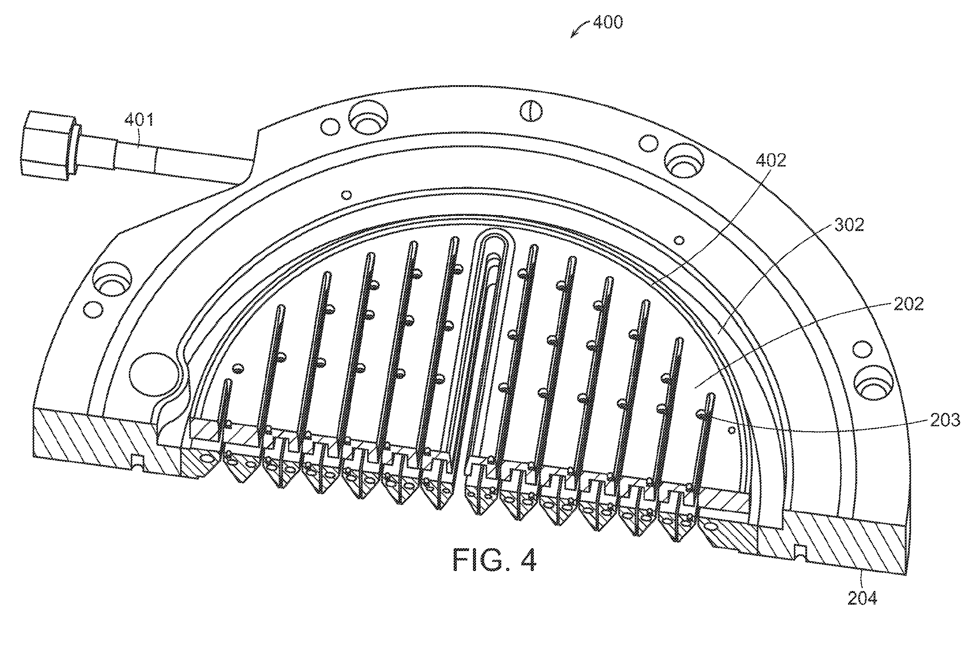

FIG. 4 illustrates a top-view of a gas flow flange 400 for a rotating disk reactor for chemical vapor deposition according to the present teaching. The top-view of the gas flow flange 400 more clearly shows some features of the gas flow flanges 200, 300 in FIG. 2 and FIG. 3, respectively. The view port 401 is shown as being positioned through the side of the gas flow flange 400. Also, the plurality of recessed slots 203 positioned into the top surface 208 of the first section 202 is clearly shown. In some embodiments, mechanical fasteners, such as fine thread screws are positioned in a plurality of recessed slots 203. These mechanical fasteners extend through to threaded sections in the second section 204 so that they fasten the first and the second sections together in precise alignment. A plurality of alignment pins in one of the first and second sections 202, 204, and a plurality of corresponding apertures dimensioned to receive the plurality of alignment pins in the other of the first and the second sections 202, 204, can be used to aid in performing a precise alignment before fastening.

The top-view of a gas flow flange 400 for a rotating disk reactor for chemical vapor deposition illustrates one embodiment of a means for preventing mixture of gasses in various sections of the gas flow flange 400. The gas flow flange 400 of FIG. 4 shows a gasket or o-ring 402 positioned at the outer surface of the annular channel 302 in the first section 202. The o-ring prevents gases from the gas inlet 304 that pass into the annular channel 302 and into the plurality of first gas input channels 206 from mixing with the gasses flowing in from the top surface to the second gas input channels 210. In some processes, the gas flowing into the gas inlet is an alkyl gas and the gas flowing to the top surface to the second gas input channels 210 is a hydride gas.

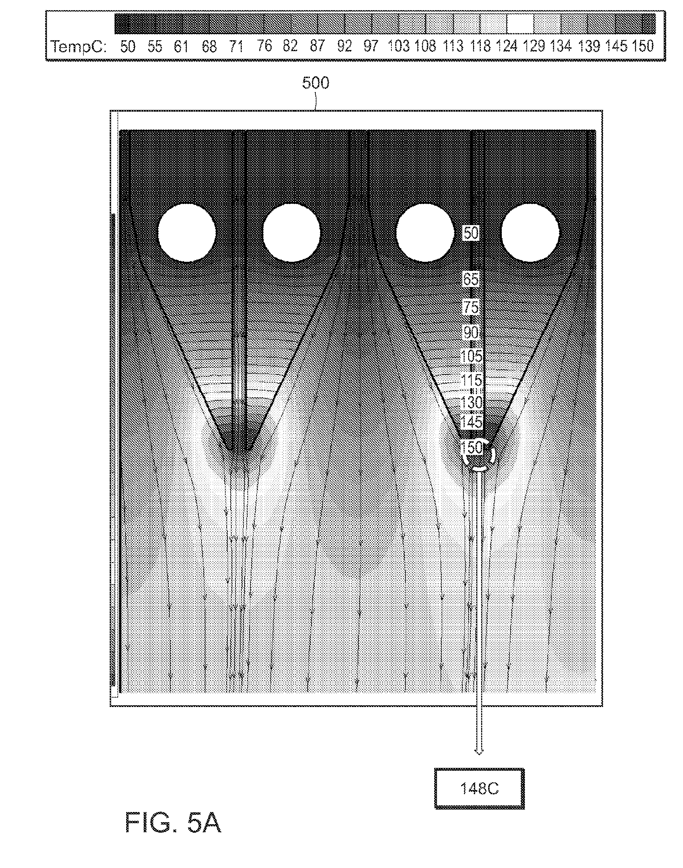

FIGS. 5A-C illustrate temperature distribution diagrams for various fluid cooling conduit designs. The diagrams FIGS. 5A-C show the plurality of first gas input channels 220 and the plurality of second gas input channels 226 both in the second section 204, where they extend through to the bottom surface 224 of the second section 204. Temperature distribution diagrams are shown for various cooling conduits having various shapes and positions. The various diagrams in FIGS. 5A-C show temperature distributions from 148 degrees C down to 100 degrees C.

FIG. 5A illustrates a temperature distribution diagram 500 showing circular cooling conduits positioned around the plurality of first gas input channels 220 as shown in the gas flow flange 300 of FIG. 3. Such circular cooling conduits are relatively easy to form because they can be drilled into the flow flange. However, drilling circular cooling conduits requires that there be enough material adjacent to the drilled conduits to prevent fracturing and cracking. Consequently, the conduits are positioned relatively high in the second section 204 of the gas flow flange. The temperature distribution diagram 500 indicates that the temperature at the plurality of first gas input channels 220 is about 148 degrees C.

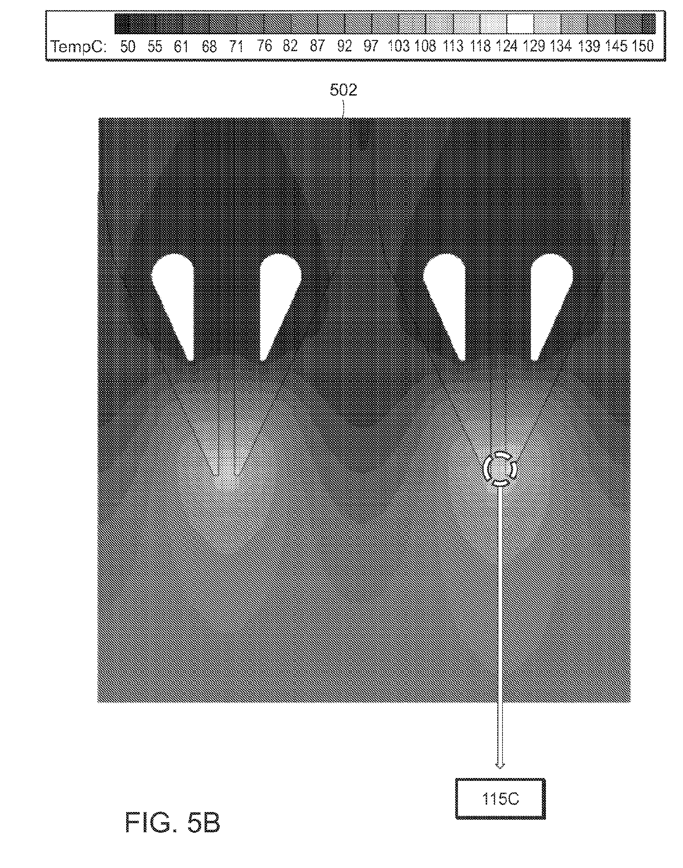

FIG. 5B illustrates a temperature distribution diagram 502 showing teardrop shaped cooling conduits positioned around the plurality of first gas input channels 220. Such teardrop shaped cooling conduits are relatively difficult to fabricate with conventional drilling and milling apparatus. However, recently developed three-dimensional metal printing techniques can be used to more easily and inexpensively form these conduits. One feature of the teardrop shaped conduits formed by three-dimensional metal printing is that they can be physically larger than drilled or milled cooling conduits, such as the cooling conduits shown in FIG. 5A, while still maintaining the integrity of the first gas input channels 220. Another feature of the teardrop shaped conduits formed by three-dimensional metal printing is that they can extend closer to the bottom surface 204 of the second section of the gas flow flange, and, therefore, can provide cooling fluid much closer to the tip that injects the gas proximate to the substrate carrier 110. Consequently, the temperature distribution diagram 502 indicates a lower temperature at the plurality of first gas input channels 220 that is about 115 degrees C.

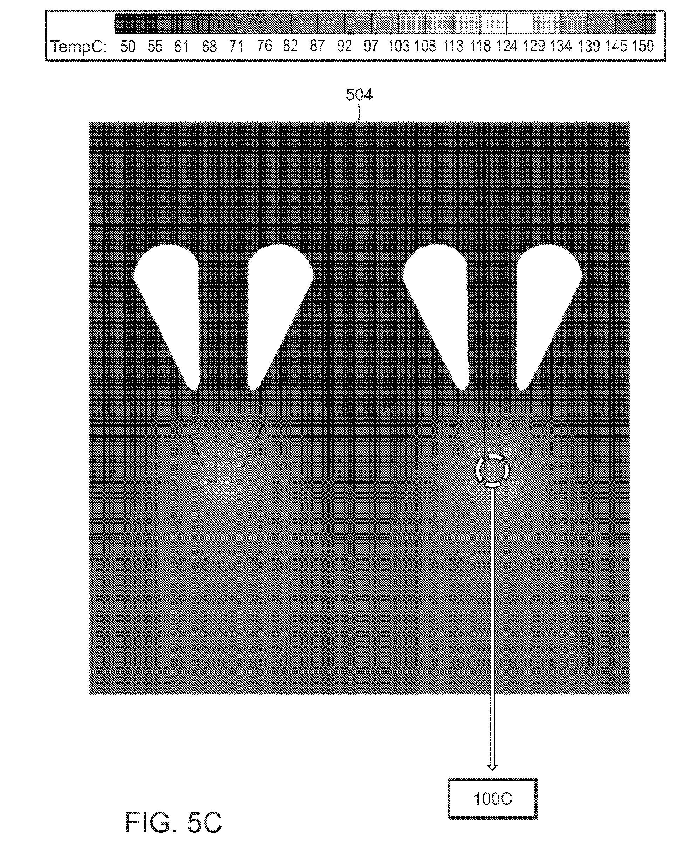

FIG. 5C illustrates a temperature distribution diagram 504 showing deep teardrop shaped cooling conduits positioned around the plurality of first gas input channels 220. Such deep teardrop shaped cooling conduits are even more difficult to fabricate with conventional drilling and milling apparatus. However, recently developed three-dimensional metal printing techniques can be used to fabricate these and many other irregularly shaped conduits that are positioned close to the edge of the first gas input channels. One feature of the deep teardrop shaped conduits is that they can be extended even closer to the bottom surface 204 of the second section of the gas flow flange and, therefore, can provide cooling fluid even closer to the tip that injects the gas proximate to the substrate carrier 110. Consequently, the temperature distribution diagram 504 indicates a lower temperature at the plurality of first gas input channels 220 that is about 100 degrees C.

### Equivalents

While the Applicant's teaching is described in conjunction with various embodiments, it is not intended that the Applicant's teaching be limited to such embodiments. On the contrary, the Applicant's teaching encompass various alternatives, modifications, and equivalents, as will be appreciated by those of skill in the art, which may be made therein without departing from the scope of the invention, as defined in the claims.

## Claims

1. A gas flow flange for a rotating disk reactor for chemical vapor deposition, the gas flow flange comprising:
a) a first section comprising a plurality of first gas input channels positioned inside and parallel to a top surface of the first section, and a plurality of second gas input channels positioned perpendicular to the top surface of the first section and extending from the top surface to a bottom surface of the first section; and
b) a second section comprising:
1) a plurality of first gas input channels positioned perpendicular to a top surface of the second section and extending through the top surface to a bottom surface of the second section, each of the plurality of first gas input channels of the second section being aligned with an output of a corresponding one of the plurality of first gas input channels in the first section;
2) a plurality of second gas input channels positioned perpendicular to and extending from the top surface to the bottom surface of the second section, each of the plurality of second gas input channels being aligned with a corresponding one of the plurality of second gas input channels in the first section; and
3) fluid cooling conduits that are formed in the second section and extending parallel to the top surface of the second section.

2. The gas flow flange of claim 1 wherein the plurality of first gas input channels of the first section is coupled to an output of an alkyl gas source, and/or wherein the plurality of second gas input channels of the first section is coupled to an output of a hydride gas source.

3. The gas flow flange of claim 1 or 2, wherein the first and second sections separate first and second gases so that they do not react until they leave the gas flow flange.

4. The gas flow flange of claim 1, 2 or 3, wherein at least some of the second gas input channels positioned perpendicular to, and extending from, the top surface to the bottom surface of the second section are formed in a shape where their cross-sectional area increases from the top surface to the bottom surface.

5. The gas flow flange of any preceding claim wherein the first section comprises a plurality of recessed slots dimensioned to receive a threaded fastener and the second section comprises a plurality of threaded sections aligned with the recessed slots for receiving the threaded fastener.

6. The gas flow flange of any preceding claim wherein the fluid cooling conduits comprise water cooling conduits,
and/or wherein the fluid cooling conduits comprise circular cooling conduits, teardrop shaped cooling conduits, oval shaped cooling conduits, or generally triangular shaped cooling conduits.

7. The gas flow flange of any preceding claim wherein the fluid cooling conduits comprise an input port that receives a fluid that passes from a central location of the second section in an outward direction to an output port.

8. The gas flow flange of any preceding claim further comprising a view port that is coupled to an input port of the first section.

9. The gas flow flange of any preceding claim wherein one of the first and second sections comprises a plurality of alignment pins and the other of the first and second sections defines a plurality of apertures dimensioned to receive the plurality of alignment pins.

10. A method of separating a first and second gas for injection into a reaction chamber, the method comprising:
a) providing the first gas to a plurality of first gas input channels positioned inside and parallel to a top surface of a first section of a flow flange, so that the first gas flows from the plurality of first gas input channels of the first section of the flow flange to a corresponding plurality of first gas input channels of a second section of the flow flange, the plurality of first gas input channels of the second section of the flow flange being positioned perpendicular to the top surface of the second section of the flow flange and extending from the top surface to a bottom surface of the second section of the flow flange, and then into a reaction chamber; and
b) providing the second gas to a plurality of second gas input channels that are positioned perpendicular to the top surface of the first section of the flow flange and extending from the top surface to the bottom surface of the first section of the flow flange, and then extending from the top surface of the second section to the bottom surface of the second section, and then into the reaction chamber.

11. The method of claim 10 further comprising flowing cooling fluid inside the second section of the flow flange, parallel to the top surface and the bottom surface of the second section,
and/or wherein the cooling fluid flows from a central input port in the second section of the flow flange, parallel to the top surface of the second section of the flow flange in an outward direction,
preferably wherein the cooling fluid comprises water.

12. The method of claim 10 or 11 wherein the first gas comprises an alkyl gas, and/or wherein the second gas comprises a hydride gas.

13. The method of claim 10, 11 or 12 wherein the second gas flows from a top surface of the second section to a bottom surface of the second section through a gas channel having a cross-sectional area that increases as the gas flows from the top surface to the bottom surface of the second section.

14. The method of any of claims 10 to 13 further comprising aligning the first section of the flow flange to the second section of the flow flange so that the plurality of first gas input channels of the second section of the flow flange are aligned with the plurality of first gas input channels of the first section, and the plurality of second gas input channels of the second section are aligned with the plurality of second gas input channels of the first section.

15. The method of any of claims 10 to 14 further comprising forming at least one of the first and the second flow flange by three-dimensional metal printing.
